(19) Europäisches Patentamt
European Patent Office
Office européen des brevets

(11) Numéro de publication : **0 128 843**
**B1**

(12) # FASCICULE DE BREVET EUROPÉEN

(45) Date de publication du fascicule du brevet : **07.09.88**

(51) Int. Cl.⁴ : **H 05 K 1/03**, C 23 C 18/18

(21) Numéro de dépôt : **84420093.1**

(22) Date de dépôt : **23.05.84**

(54) **Substrats métallisables pour circuits imprimés et leur procédé de préparation.**

(30) Priorité : **27.05.83 FR 8309027**

(43) Date de publication de la demande : **19.12.84 Bulletin 84/51**

(45) Mention de la délivrance du brevet : **07.09.88 Bulletin 88/36**

(84) Etats contractants désignés : **AT BE CH DE FR GB IT LI LU NL SE**

(56) Documents cités :
**EP-A- 0 038 885**
**FR-A- 2 098 242**
**FR-A- 2 128 376**
**FR-A- 2 163 383**
**GB-A- 2 016 487**

(73) Titulaire : **CIBA-GEIGY AG**
**Klybeckstrasse 141**
**CH-4002 Basel (CH)**

(72) Inventeur : **Cassat, Robert**
**Chemin de Crapon**
**F-69360 - Ternay (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

La présente invention se rapporte à des substrats isotropes métallisables constitués par une matière polymérique, des charges de renforcement et des charges pulvérulentes ainsi qu'un procédé de préparation desdits substrats.

Dans le domaine de l'électronique la course aux densités d'intégration élevées en matière de circuits intégrés, se traduit par exemple, par la nécessité de disposer des boîtiers rigides munis d'un grand nombre de sorties. Les « chips carriers » représentent une solution convenable pour ce problème mais leur développement est freiné tant par leur prix élevé que par des problèmes techniques non encore résolus. Pour l'instant ces boîtiers céramiques sont souvent montés sur des substrats céramiques et soudés par des plots métalliques.

Mais les supports céramiques sont chers, de manipulation délicate car fragiles et de dimensions trop faibles. Il se posait donc le problème de disposer de supports présentant un coefficient de dilatation thermique voisin de celui du silicium ou des céramiques, non sensibles à l'humidité, isotropes et présentant de bonnes propriétés mécaniques à froid comme à chaud à des températures pouvant aller jusqu'à 250 °C.

De nombreuses solutions ont été proposées dont certaines font déjà l'objet d'une commercialisation, mettant en œuvre des matières polymériques comme les résines époxy, les polyimides ou les mélanges d'époxy et de polyimides et des tissus de renforcement en fibres de verre ou de quartz, en fibres de bore ou de carbone ou en fibre de polyamides aromatiques. Ces substrats présentent toutefois un certain nombre d'inconvénients. Ainsi par exemple les substrats polyimides renforcés par fibres de verre présentent un coefficient de dilatation trop important. Les substrats polyimides renforcés tissu de Kevlar[R] (polyamide aromatique) sont difficiles à préparer et ne permettent pas un bon perçage de trous. De plus ils sont anisotropes.

Il est par ailleurs connu par les brevets français 2 156 452 et 2 163 383 de réaliser des articles non tissés constitués par des nappes de fibres infusibles ou présentant des points de fusion supérieurs à 180 °C liées par des polymères de type polyamide-imide ou polyimide. Toutefois la structure poreuse de ces non tissés ainsi que leurs propriétés mécaniques sont entièrement différentes des substrats selon l'invention.

Un des buts de la présente invention est d'obtenir des substrats présentant outre une faible reprise d'humidité de l'ordre de 0,03 à 0,5 %, un coefficient de dilatation thermique entre $-65$ °C et 125 °C variant de 3 à $12 \times 10^{-6}$ cm/cm/°C et une bonne isotropie.

Un autre but de l'invention est d'obtenir à partir des substrats métallisables des supports métallisés selon une localisation prédéterminée pouvant être utilisés comme support de circuits imprimés ou pouvant remplacer les supports céramiques évoqués plus haut.

Les substrats métallisables isotropes selon l'invention sont caractérisés en ce qu'ils présentent un coefficient de dilatation thermique entre $-65$ °C et 125 °C variant de 3 à $12 \times 10^{-6}$ cm/cm/°C et en ce qu'ils sont constitués par :

— de 10 à 60 % en poids de fibrettes dont la longueur moyenne est inférieure ou égale à 25 mm,
— de 10 à 70 % en poids de charges pulvérulentes ou sous forme de particules,
— de 20 à 70 % en poids de liant pour des fibrettes et charges,

les fibrettes comprenant une proportion majoritaire de fibrettes de matières polymériques dont les propriétés mécaniques sont maintenues au-dessus de 200 °C et qui présentent un coefficient de dilatation thermique faible, au sens ci-avant, voire négatif,

les charges pulvérulentes comprenant de 40 à 100 % en poids de particules d'oxyde cuivreux de granulométrie comprise entre 0,1 et 5 microns,

le liant comprenant de 25 à 100 % en poids de polymère à groupements imides.

Par substrats métallisables on entend des substrats qui par leur composition ou leurs structures peuvent comporter ou recevoir à leur surface une couche de métal. Ces substrats peuvent être rigides ou semi-rigides selon la composition du matériau support isolant. Par substrat semi-rigide on entend un matériau pouvant subir une déformation élastique par incurvation.

La métallisation peut être réalisée soit par apport d'un film de métal qui est contre-collé à la surface du substrat soit dépôt d'une couche comportant une substance qui pourra par un traitement chimique ultérieur être transformé en métal ou qui servira d'amorce à un dépôt métallique par voie électrolytique ou chimique. Cette métallisation peut aussi être réalisée par traitement chimique direct du substrat qui contient alors dans sa masse un composé capable d'être transformé en métal.

Par substrats isotropes on entend des substrats isotropes notamment dans le plan dont les propriétés physiques ne dépendent pas de la direction selon laquelle on effectue les mesures et sont identiques dans toutes les directions.

Ces substrats sont obtenus en réalisant en un premier temps un non tissé par voie humide à partir de fibrettes de matières polymériques, dont les propriétés mécaniques sont maintenues au-dessus de 200 °C et qui présentent un coefficient de dilatation thermique faible, voire négatif, d'un liant et de charges.

De telles fibres peuvent être choisies parmi les aramides qui sont commercialisées sous les

appellations de NOMEX, de KEVLAR ou de KERMEL ou dans les cas où les exigences dans les propriétés de tenue en température sont un peu moins élevées, parmi les fibres de polyéthylène glycol téréphalate. On préfèrera cependant les aramides tels que décrits dans le brevet français 2 079 785 et plus particulièrement ceux décrits dans le brevet français 1 526 245. Ces fibres sont habituellement sous forme de fibrettes dont la longueur ne dépasse pas 25 mm.

A ces fibrettes peuvent être associées en proportion minoritaire des fibres inorganiques comme les fibres de verre, les fibres de carbone, les fibres d'oxyde d'aluminium et de zirconium, les fibres d'amiante ou de bore et de façon générale les whiskers que l'on utilise déjà dans d'autres applications.

Le taux de fibre dans la composition totale sera compris entre 10 % et 60 % en poids.

Comme liant on utilisera essentiellement des polymères ou des prépolymères à groupements imides qui à l'état durci sont fortement réticulés présentant de ce fait de très hauts modules et des taux de dilatation thermique très faibles. On pourra ainsi utiliser des polyimides ou des polyamides-imides ou même éventuellement des polyétherimides. Comme polyimide on utilise de préférence un prépolymère obtenu à partir d'un N, N' bis-imide d'acide dicarboxylique non saturé de formule générale :

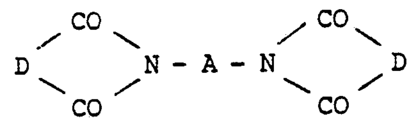

(1)

dans laquelle D représente un radical divalent contenant une double liaison carbone et A est un radical organique divalent possédant 2 à 30 atomes de carbone, et d'une polyamine de formule générale :

$$R(NH_2)_x \qquad (2)$$

dans laquelle x est un nombre entier au moins égal à 2 et R représente un radical organique de valence x, la quantité de bis-imide étant de 0,55 à 25 moles par groupement molaire $—NH_2$ apporté par la polyamine.

De tels polyimides sont décrits en particulier dans le brevet français 1 555 564 mais de nombreux dérivés de ces polymères peuvent convenir. Ainsi la résine polyimide peut encore être obtenue par réaction entre le bis-imide, la polyamine et divers adjuvants tels que par exemple des mono-imides (selon le brevet français N° 2 046 498), des monomères, autres que des imides, comportant un ou plusieurs groupements polymérisables du type $CH_2C=$ (selon le brevet français N° 2 094 607), des polyesters insaturés (selon le brevet français N° 2 102 878) ou des composés organosiliciques hydroxylés (selon le brevet français N° 2 422 696). Dans le cas où l'on utilise de pareils adjuvants, il faut rappeler que la résine polyimide peut être obtenue soit en chauffant directement les trois réactifs (bis-imide, polyamine et adjuvants) ensemble, soit en chauffant le produit de réaction ou le mélange de l'adjuvant avec un prépolymère de bis-imide et de polyamine préalablement préparé.

On choisira de toute façon des prépolymères qui peuvent se trouver sous forme de poudre. Plus préférentiellement encore, on utilise dans la présente invention une résine polyimide issue de la réaction entre un bis-maléimide comme le N,N'-4,4'-diphénylméthane bis-maléimide et une diamine primaire comme le diamino-4,4' diphénylméthane et éventuellement l'un des divers adjuvants précités.

Les prépolymères ou polymères de polyamide-imides utilisés comme liants dans l'invention peuvent être définis comme comportant une pluralité de motifs de formule :

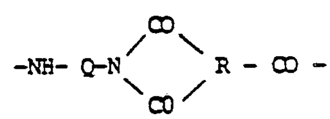

(I)

dans laquelle le symbole Q représente un radical divalent comportant au moins un noyau benzénique et le symbole R représente un radical aromatique trivalent.

Comme exemples de radicaux représentés par Q, on peut citer les radicaux m-phénylène, p-phénylène, p · p' diphénylène ou des radicaux de formule :

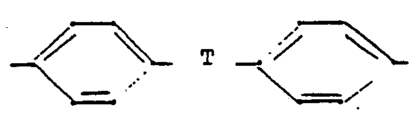

(II)

dans laquelle le symbole T peut représenter un atome ou groupement divalent tel que $—O—$, $—CH_2—$, $—C(CH_3)_2—$, $—SO_2—$, $—N{=}N—$.

Comme exemples de radicaux représentés par le symbole R, on peut citer les radicaux trivalents de formules :

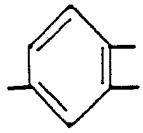 , 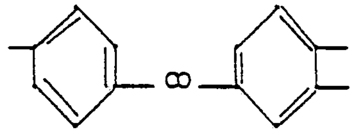 , 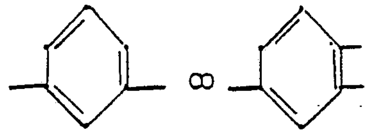

Les polyamide-imides décrits ci-avant peuvent être préparés suivant diverses techniques, telles que celles décrites dans les brevets anglais 570 878 et 1 281 446, le brevet américain 3 260 691, les brevets français 1 386 617, 1 473 600, 1 501 198, 1 559 357 ou 1 576 844.

Parmi ces polyamide-imides on mentionnera en particulier ceux qui sont obtenus à partir d'anhydride trimellique et d'un dérivé difonctionnel de formule :

$$X—Q—X \qquad \text{(III)}$$

dans laquelle le symbole X représente un groupement NCO ou un groupement de formule $—NHCOR_1$, le symbole $R_1$ pouvant représenter un radical alcoyle ayant de 1 à 6 atomes de carbone ou un radical phényle ou méthylphényle.

On utilise de préférence dans l'invention des polyamide-imides permettant la présentation du polymère sous forme de poudre. Les polytrimellamide-imides provenant de la réaction de l'anhydride trimellique avec le diisocyanato-4,4′ diphénylméthane ou diisocyanato-4,4′ diphényléther conviennent à la fabrication des substrats conformes à l'invention.

Ces résines peuvent être utilisées en mélange avec une proportion pouvant varier de 0 à 75 % en poids d'autres résines thermodurcissables comme par exemple des résines époxy telles que les produits de réaction de l'épichlorhydrine sur le bis phénol A. Le taux de résine sera généralement compris entre 20 et 70 % en poids du total de la composition et de manière avantageuse sera 31 %.

Comme charge on utilisera essentiellement de l'oxyde cuivreux. Cet oxyde doit se présenter sous la forme de particules de granulométrie comprise entre 0,1 et 5 microns. A cet oxyde métallique peut être adjoint une certaine proportion de charge inerte On choisira les charges ayant un faible taux de dilatation. De telles charges peuvent être pulvérulentes ou sous forme de particules comme les paillettes de mica.

Le taux de charge total sera généralement compris entre 10 et 70 % en poids du total de la composition ; la teneur maximale en charge inerte représentera 60 % de l'ensemble des charges.

Les charges seront constituées de préférence pour 100 à 60 % en poids d'oxyde cuivreux et pour 0 à 40 % en poids d'une charge inerte.

La composition constituée de fibres, du liant et des charges sera mise en œuvre par voie humide, appelée aussi voie papetière. Cette voie consiste à mettre en suspension directement dans l'eau l'ensemble des constituants dans un mélangeur appelé « pile » par les papetiers. Les fibres de faible dimension, le liant sous forme de poudre ainsi que les charges pulvérulentes ou en paillettes forment alors une pâte qui est mise en forme sur une machine de type machine à papier constituée par un cuvier d'où s'écoule la pâte sur un tapis roulant poreux permettant une première élimination de l'eau. Un système d'essorage éventuellement sous légère pression puis application du vide puis séchage à une température de l'ordre de 70 à 110 °C permet d'obtenir une sorte de carton dans lequel le liant se trouve à l'état de polymère, ou, le cas échéant, de prépolymère de faible masse moléculaire. Sa densité est en général comprise entre 0,3 et 2.

Cette sorte de carton sera ensuite découpé en format puis pressé à chaud. On met en œuvre habituellement une presse à plateau travaillant sous $10^6$ à $3 \cdot 10^7$ Pa (10 à 300 bars) et une température supérieure à 70 °C. On peut prévoir des cycles durant lesquels pression et température sont augmentées par paliers. Ceci dépend essentiellement de la nature du liant choisi.

Dans le cas des prépolymères polyimides préférés obtenus à partir d'un bis-imide, d'une polyamine et éventuellement d'un des adjuvants précités (ayant en général un point de ramollissement compris entre 50° et 200 °C), la température de pressage se situe généralement entre 70° et 280 °C. De préférence, dans le but de permettre un accrochage (ou assemblage) efficace des différents constituants, la température est supérieure à 150 °C.

Ces conditions de température de pressage s'appliquent également aux autres types de prépolymères thermodurcissables entrant dans le cadre de la présente invention. En général, le chauffage des prépolymères permet d'obtenir successivement leur ramollissement et leur durcissement et, celui des polymères de faible masse moléculaire, leur fusion et leur durcissement. On peut naturellement procéder à un recuit de l'ensemble par exemple pendant quelques heures à 200 °C ou plus.

La technique de fabrication des substrats métallisables conformes à l'invention qui vient d'être décrite présente de nombreux avantages.

Comme on l'a déjà mentionné, cette fabrication est simplifiée du fait de l'emploi d'un nombre restreint de constituants et elle permet de s'affranchir du processus d'imprégnation de structure de renforcement par voie collodion qui est polluant.

Mais il y a d'autres avantages. La préparation du carton par voie papetière est un procédé à grand rendement. De plus, la voie papetière autorise le recyclage des déchets : il n'y a aucun inconvénient à réintroduire dans la pile les déchets de carton formés avant pressage. Par ailleurs, on note qu'il n'y a

pratiquement pas de fluage de polyimide lors du pressage final à chaud. En définitive, cette possibilité de recyclage, liée au fluage pratiquement nul lors du pressage, assure une perte très faible de résine en cours de fabrication.

Les formats pressés à chaud éventuellement recuits peuvent ensuite subir un traitement de métallisation. Il peut être nécessaire au préalable de mettre au jour les grains d'oxyde cuivreux par traitement mécanique : sablage — rouleaux abrasifs — frottement avec une pâte abrasive et/ou traitement chimique.

On a trouvé que la transformation de l'oxyde cuivreux en cuivre métallique peut être conduite facilement et de manière quantitative par action des borohydrures. La transformation est représentée par la réaction :

$$4\,Cu_2O + BH_4^- \longrightarrow 8\,Cu + B(OH)_3 + OH^-$$

Cette facilité de réaction est probablement due à l'effet catalytique du cuivre métal qui pourrait s'expliquer par la formation intermédiaire d'hydrure de cuivre instable.

Les borohydrures utilisables dans la présente invention englobent des borohydrures substitués aussi bien que des borohydrures non substitués. Des borohydrures substitués dans lesquels au plus trois atomes d'hydrogène de l'ion borohydrure ont été remplacés par des substituants inertes comme par exemple des radicaux alkyles, des radicaux aryles, des radicaux alkoxy peuvent être utilisés. On fait appel à des borohydrures alcalins dans lesquels la partie alcaline consiste en du sodium ou du potassium. Des exemples typiques de composés qui conviennent sont : le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact du format avec une solution de borohydrure dans l'eau ou dans un mélange d'eau et d'un solvant polaire inerte comme par exemple un alcool aliphatique inférieur. On donne la préférence aux solutions purement aqueuses de borohydrure. La concentration de ces solutions peut varier dans de larges limites et elle se situe de préférence entre 0,05 et 1 % en poids d'hydrogène actif du borohydrure par rapport à la solution. Le traitement réducteur peut être effectué à température élevée, cependant on préfère le mettre en œuvre à une température voisine de la température ambiante, par exemple entre 15 °C et 30 °C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien déterminée. Après réduction on rince le format.

En début de réduction, la réaction concerne essentiellement les grains d'oxyde cuivreux qui se trouvent en surface du substrat et qui sont en contact direct avec l'agent réducteur. Du fait de l'effet catalytique du cuivre métal, la réaction de réduction va se poursuivre ensuite dans l'épaisseur du format et ceci bien que les résines utilisées ne présentent pas un caractère hydrophile particulièrement marqué. C'est donc en jouant principalement sur la durée du traitement qu'il est possible de contrôler aisément l'importance de la réduction opérée. Pour obtenir une résistivité répondant aux valeurs souhaitées, la durée du traitement qui est nécessaire est en général assez courte et, selon les proportions d'oxyde compris dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique ou des chlorures de métaux tels que le chlorure de cobalt-II, de nickel-II, de fer-II, de manganèse-II, de cuivre-II.

La réduction qui est opérée dans l'intervalle de temps indiqué ci-avant concerne une partie seulement de l'épaisseur du format. A noter que pour des applications électriques, on veille à ne réduire qu'une partie seulement de l'épaisseur du format afin de conserver une partie interne non réduite, isolante pour éviter tout phénomène parasite de pontage conducteur. Par contre s'il a été prévu des trous, on constate qu'une couche, au minimum de même épaisseur qu'en surface est aussi réduite sur le pourtour des trous.

Etant donné l'état très divisé du cuivre obtenu après le traitement réducteur, on devait s'attendre à ce que son oxydation à l'air soit rapide. Or on a constaté qu'il n'en est rien et que le niveau de la résistivité superficielle du format après réduction n'évolue pas pendant plusieurs jours de conservation à l'air ambiant.

Il est donc possible de stocker dans cet état le substrat réduit. On peut prévoir à titre de précaution soit un rinçage incomplet laissant des traces de réducteur à la surface du format, soit l'addition au bain de rinçage d'un agent réducteur particulier par exemple d'hydroquinone soit la protection du format rincé et séché par enduction d'un film protecteur par exemple de photorésist.

Le substrat réduit peut ensuite être métallisé par dépôt d'une couche de cuivre, de nickel ou d'un autre métal. Cette métallisation peut être faite par voie électrochimique, mais il a été constaté et ceci constitue un des avantages essentiels liés à la mise en œuvre de la présente invention, qu'elle peut être faite aussi directement par voie électrolytique. Dans certaines applications, il n'est pas rare de rechercher

un dépôt de couche métallique d'au moins 20 microns, aussi la possibilité de pouvoir utiliser directement la voie électrolytique correspond-elle vraiment à un procédé industriellement rentable. Il est possible bien entendu de procéder, de manière classique, d'abord à une métallisation électrochimique, puis de renforcer ce premier dépôt par un dépôt ultérieur électrolytique. Pour avoir une description détaillée des conditions opératoires propres à la métallisation électrochimique, on peut se reporter à l'ouvrage « Encyclopedia of Polymer Science and Technology, 1968, volume 8, pages 658 à 661". Les proportions des constituants du bain électrochimique, la durée de l'immersion du format, la température et les autres conditions opératoires sont déterminées dans chaque cas particulier de manière connue en soi pour obtenir les meilleurs résultats.

La métallisation par électrolyse est bien connue ; cf. notamment « Encyclopedia of Polymer Science and Technology, 1968, volume 8, pages 661 à 663". Le format convenablement réduit constitue la cathode et le métal à déposer l'anode. Tous deux sont immergés dans un électrolyte traversé par un courant. Par exemple dans le cas d'un cuivrage électrolytique, le métal déposé peut procéder du cuivre monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte : un sel alcalin ou alcalino-terreux, un acide (bain de cuivrage acide au sulfate de cuivre) ou une base (bain d'étamage alcalin au stannate) pour augmenter la conductivité de l'électrolyte ; un agent tampon pour éviter les variations rapides du pH ; des corps modifiant la structure des électrodépôts comme par exemple des colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique, distance anode-cathode, conditionnement superficiel des électrodes, etc.) ; le réglage de ces différents paramètres sera fait dans chaque cas particulier de manière connue en soi.

Le fait de pouvoir propager la réduction dans l'épaisseur du substrat va permettre d'engendrer les avantages suivants : lors de la métallisation, il y aura un ancrage profond du métal déposé dans le substrat résineux ; dans le cas d'une soudure avec un apport de métal formant un alliage, l'alliage pourra migrer également à l'intérieur du substrat puisqu'il y a une réelle continuité du cuivre dans l'épaisseur du substrat ; dans le cas d'une métallisation destinée à jouer le rôle de drain thermique, il sera possible d'agir sur le transfert thermique de la résine en faisant progresser plus ou moins la réduction dans la masse du format.

Selon la durée du traitement électrolytique on pourra obtenir des couches métalliques dont l'épaisseur est de l'ordre du micron, couches enracinées dans le substrat et présentant une bonne cohésion, contrairement à ce qui se passe avec des dépôts « Electroless ». Des substrats comportant une couche aussi mince de métal présentent un grand intérêt pour la réalisation de circuits imprimés, car ils permettent lors des traitements ultérieurs de gravure de supprimer les défauts et notamment la sous-gravure. On peut ainsi augmenter la densité de la circuiterie et augmenter la fiabilité des circuits.

Il va de soi que l'on peut obtenir aussi des dépôts métalliques beaucoup plus importants, de l'ordre de 20 à 50 microns par exemple, dépôts correspondant aux techniques actuellement utilisées pour la réalisation de circuits imprimés. On peut de même déposer par fusion ou par voie électrolytique des couches d'alliage de type plomb/étain.

La réalisation de circuits imprimés à partir de substrats réduits peut alors se faire selon les procédés additifs classiques et la réalisation de circuits à partir de substrats réduits et métallisés par voie électrolytique, par gravure classique.

Le procédé selon l'invention permet aussi d'obtenir des substrats métallisables ou métallisés qui comportent une couche de métal ancrée dans le polymère pouvant être aussi faible qu'un micron tout en étant cohérente et résistante. Ce procédé se distingue des procédés antérieurs tant par sa simplicité que par son faible coût et par le très grand nombre de possibilités ouvertes.

De plus sa technologie est adaptée aux équipements existants. Les possibilités de variantes sont très nombreuses, car à chaque étape du procédé il est possible de l'interrompre par exemple par un stockage du produit semi-fini pour le reprendre ultérieurement.

Les exemples suivants donnés à titre non limitatif illustrent l'invention et montrent comme elle peut être mise en œuvre.

### Exemple 1

Dans une cuve de 5 000 litres, appelée « pile » dans l'industrie papetière on incorpore successivement :

2 000 l d'eau,

25 kg de pulpe Kevlar$^R$.

Lorsque la pâte apparaît bien homogène, on charge progressivement, toujours sous agitation 30 kg de résine polyimide commercialisée sous le nom de Kerimid 601 par Rhône-Poulenc, en poudre de granulométrie inférieure à 60 microns.

L'agitation est maintenue une dizaine de minutes, et on charge enfin 40 kg de $Cu_2O$ de granulométrie moyenne 1 micron.

Progressivement la pâte en suspension se colore en rouge, tandis que les grains de $Cu_2O$ se fixent sur la pulpe de KEVLAR. 1 000 litres d'eau supplémentaires sont introduits. Enfin, on incorpore 3 kg de fécule cationique en solution aqueuse et 4 litres d'une solution de silice colloïdale. Après incorporation de la silice colloïdale, l'agitation est limitée au strict minimum assurant sa répartition dans la masse, afin de ne pas gêner la précipitation permettant la fixation des charges pulvérulentes sur le renfort fibreux.

Cette pâte est transvasée dans un cuvier à partir duquel s'effectue l'alimentation de la machine papetière.

La largeur utile du tapis filtrant est de 2,60 m et sa longueur de 10 mètres. Le tapis est constitué d'une forte toile nylon R formant bande sans fin, défilant à la vitesse (réglable) de 2 mètres/minute, et animée transversalement d'un mouvement de vibration.

Dans le premier quart du parcours la toile repose sur un plan continu, interdisant pratiquement l'écoulement de l'eau. A ce niveau la pâte, du fait des vibrations se répartit de façon homogène.

Dans les deux quarts suivants la toile est libre, et l'écoulement d'eau s'effectue naturellement.

Dans le dernier quart la toile passe sur des caissons de décompression assurant un essorage forcé.

Le cylindre final de renvoi de la toile est également sous vide sur une fraction de sa circonférence. Le dépôt de pâte subit par ailleurs un pressage en continu par un cylindre rotatif appuyant sur le précédent selon une génératrice.

Lorsque la pâte essorée, se présentant sous la forme d'une feuille continue de 4 mm d'épaisseur et de 2,60 m de large, échappe de la partie du cylindre en décompression, elle est transférée sur un tapis continu qui l'achemine vers le four de séchage, long de 20 m, permettant une élimination totale de l'eau sous forte ventilation et température faible (dans ce cas 70 °C).

En sortie de four le carton d'un grammage de 1 500 g/m$^2$ est découpé en formats de 1 000 × 1 000 mm et d'épaisseur d'environ 3,5 mm. Ce produit semi-ouvré dans lequel la résine est encore sous forme de prépolymère est ensuite pressé sous $2 \cdot 10^7$ Pa (200 bars) à 220 °C pendant 1 heure. La plaque résultante de coloration rouge brique a une épaisseur de 1,2 mm. D'autres essais de stratification conduits sur des empilages de « carton » et dans des conditions de température, pression et durée identiques à celles indiquées précédemment conduisent à des stratifiés ayant jusqu'à 10 mm d'épaisseur sans tendance au délaminage des plis constitutifs.

Sur une éprouvette de 4 × 6 × 10 mm (la dimension de 10 mm étant prise dans le plan du stratifié) une mesure de coefficient de dilatation est effectuée de la température ambiante à 250 °C, selon la dimension de 10 mm, sur un appareil de « Thermomechanical analysis » de DU PONT de type 900.

Le coefficient ainsi déterminé est de $12 \times 10^{-6}$ cm/cm/C°. Un stratifié de 1 mm d'épaisseur est décapé superficiellement à l'aide d'un papier abrasif fin puis soigneusement dépoussiéré par rinçage à l'eau en cuve à ultrason. Le décapage superficiel est conduit de telle sorte que la pellicule brillante (film superficiel de résine pure) soit éliminée totalement. Après cette opération la charge d'oxyde de cuivreux est accessible à la surface du substrat et apte à subir l'opération de réduction chimique qui confère au substrat une bonne conductibilité de surface.

La solution réductrice est préparée de la façon suivante :

Dans un erlen de 1 000 ml on introduit dans l'ordre sous agitation et après dilution de chaque constituant :

— 500 ml d'eau distillée,

— 2,5 g de soude en pastilles,

— 5 g de sel de sodium d'un carboxyméthylcellulose (type 7ME, « medium viscosity », PM 250 000 d'HERCULES),

— 25 g de borohydrure de potassium,

— 5 cm$^3$ d'une solution aqueuse à 1 % de Cemulsol DB 311 de SFOS.

Le substrat est enduit par la solution réductrice et après un contact de 3 mn la solution et les sous-produits de la réaction sont éliminés par lavage à l'eau distillée accompagné d'un léger brossage. Le substrat est rincé à l'alcool et séché. La résistance électrique mesurée entre deux points de la surface distants d'une vingtaine de cm, à l'aide d'électrodes ponctuelles varie de 10 à 70 ohms.

La surface est apte à recevoir un dépôt métallique de renforcement par une méthode électrolytique.

## Exemple 2

Sur l'équipement décrit dans l'exemple 1 on incorpore successivement dans la pile :

— 3 000 l d'eau

— 20 kg de pulpe Kevlar.

Puis après homogénéisation de la pâte,

— 100 kg d'un compound polyimide (Kerimid 601 de RHONE-POULENC) et oxyde cuivreux : 40/60 parties en poids (ce compound obtenu par fusion en four d'un mélange pulvérulent K601/$Cu_2O$ a été ensuite broyé finement et ne contient pas de grains de taille supérieure à 40 microns).

Après un nouveau temps d'homogénéisation sous forte agitation au terme duquel il apparaît que la majeure partie du compound est fixée sur la pulpe, 80 kg de charge inerte sont introduits.

Nous utilisons pour cela un mica Muscovite 16 mesh ayant subi un traitement de surface à sec par un agent de couplage (Triéthoxysilane de vinyle, référence A 151 de UNION CARBIDE, au taux de 1 %). Une

conséquence secondaire du traitement à sec est la réduction de la taille moyenne des splits de mica mis en œuvre.

Après homogénéisation, 1 000 l d'eau supplémentaire, environ, sont ajoutés pour ajuster la consistance de la pâte, puis 6 kg de fécule cationique en solution dans l'eau et enfin 8 litres de silice colloïdale en solution dans l'eau.

Après cette dernière incorporation, l'agitation est réduite au strict minimum pour permettre une bonne répartition dans la masse. Le liquide apparaît alors clair, les fines particules s'étant fixées sur la pulpe Kevlar du fait de la précipitation du système silice colloïdale-fécule cationique. Le contenu de la pile est transféré dans le cuvier d'où il alimente la machine papetière décrite dans le premier exemple.

La vitesse de défilement de la toile est d'environ 2 m/mn et le « carton » résultant a une épaisseur de 6 mm lorsqu'il se présente à l'entrée du four de séchage. A la sortie du four, réglé à 80 °C, l'épaisseur du carton est toujours de 6 mm, son grammage est de 2 200 g/m$^2$. La découpe du « carton » continu est faite en formats de 1 000 × 1 000 mm.

Ces formats, parfaitement secs, dans lesquels la résine est demeurée sous forme de prépolymère sont pressés à chaud sous 150 bars selon le cycle thermique suivant :

Chargement en presse chaude à 160 °C.

Affichage de la consigne à 200 °C dès le chargement (température atteinte après 20 mn).

Durée totale du cycle 1 heure. Déchargement à chaud. Puis recuit 12 heures à 250 °C. La plaque pressée résultant de l'opération est de couleur rouge brique, et a une épaisseur de 1,6 mm.

Comme dans l'exemple 1, le coefficient de dilatation est déterminé sur appareil de « T.M.A. » DU PONT selon une direction prise dans le plan du stratifié. Les éprouvettes de mesure sont découpées de telle sorte que les axes de mesure fassent à partir d'une direction arbitraire prise dans le plan de stratification des angles de 0-45 et 90°.

Les coefficients de dilatation, de la température ambiante à 250 °C, sont comparables quelle que soit l'éprouvette et compris entre 5 et 6 × $10^{-6}$ cm/cm/°C. Un élément de stratifié de 20/20 cm est décapé superficiellement par sablage puis percé selon un schéma préétabli.

Le format ainsi percé est traité par la solution réductrice décrite dans l'exemple 1. Pour cela le format est posé à la surface de la solution et immergé de façon à ce que le liquide pénètre dans les trous en chassant l'air, puis recouvre la face supérieure. La plaque est alors retirée et placée verticalement pour égouttage.

Après 3 mn de contact, la solution réductrice est rincée à l'eau distillée sous léger brossage. Le format est rincé ensuite à l'alcool et séché. Sa surface est cuivrée et conductrice de l'électricité, ainsi que les parois des trous.

La plaque perforée ainsi obtenue est alors soumise aux opérations permettant la fabrication d'un circuit imprimé double face à trous métallisés :

— Dépôt recto-verso de photorésist.

— Insolation recto-verso au travers de masque.

— Développement du photorésist.

— Renforcement électrolytique dans un bain acide de sulfate de cuivre avec anode de cuivre, dans les plages sans photorésist ainsi que dans les trous. Lorsque l'épaisseur du dépôt atteint une trentaine de microns en moins d'une heure, le circuit est rincé à l'eau.

— Strippage du photorésist restant.

— Gravure non sélective au perchlorure de fer jusqu'à disparition complète du cuivre dans les zones non renforcées.

— Après rinçage à l'eau, immersion rapide dans un bain d'acide sulfurique dilué pour redonner un aspect brillant au circuit.

— Rinçage soigneux à l'eau distillée puis à l'alcool et enfin séchage.

Au terme de cette opération nous disposons d'un circuit double face à trous traversants métallisés dont le coefficient de dilatation du substrat est compatible avec celui de composants actifs en silicium. Il est donc possible de procéder à l'implantation directe de ces composants (par collage par exemple, avec une colle conductrice) conduisant ainsi à un circuit hybride à trous traversants conducteurs.

## Exemple 3

On prépare, comme indiqué dans l'exemple 1 une pâte pour opération papetière. Sa composition est semblable à celle de l'exemple 1 :

25 kg de pulpe Kevlar

30 kg de résine polyimide K601 (granulométrie inférieure à 60 microns)

40 kg de $Cu_2O$ (granulométrie inférieure à 1 micron)

3 kg de fécule cationique

4 litres de solution de silice colloïdale.

La machine papetière est modifiée de telle sorte qu'en bout de bande d'égouttage la nappe soit reprise sur un cylindre de 2 m de diamètre. Dans ce cas la technique consiste à recueillir sur ce cylindre plusieurs tours de nappe de faible grammage de façon à faire croître l'épaisseur de la nappe d'origine. Au terme de cette croissance le dépôt sur le cylindre est tranché selon une génératrice et transféré sur le

tapis roulant conduisant au four. Pour un réglage donné de la nappe formée en continu, il est possible de compter le nombre de couches successives reprises sur le cylindre, ou de suivre l'épaississement du dépôt sur cylindre avec un palpeur signalant lorsque l'épaisseur requise est atteinte.

Dans sa partie de formation de nappe en continu, la machine est réglée pour former une nappe d'environ 200 g/m². Cette nappe reprise sur cylindre est tranchée tous les 7 tours alors que le palpeur indique une épaisseur de 4 mm. Le format de 2 m × 2,60 m est séché à 70 °C puis coupé en formats de 1 m × 1,20 m (les chutes sont récupérées pour être recyclée dans une opération ultérieure).

Après stratification comme indiqué dans l'exemple 1 et découpe d'échantillons de 4 × 6 × 10 mm. Le coefficient de dilatation est déterminé, selon la dimension de 10 mm, prise dans le plan du stratifié, de la température ambiante à 250 °C, sur TMA DU PONT 900.

Ce coefficient est de $5 \times 10^{-6}$ cm/cm/°C quelle que soit la direction de mesure prise dans le plan de stratification.

Exemple 4

On renouvelle l'essai décrit dans l'exemple 3, mais en substituant à la pulpe Kevlar, de la fibre Kevlar coupée de longueur moyenne 25 mm. Avant introduction en pile, la fibre coupée diluée dans 2 000 litres d'eau est travaillée en affineuse papetière pendant une heure. Au terme de ce traitement, la pulpe obtenue est examinée au microscope. Il apparaît que la fibre, à l'origine parfaitement cylindrique, comporte maintenant des ébarbures susceptibles d'améliorer l'accrochage des fibres entre elles et la rétention des charges pulvérulentes.

La suite des opérations est identique à celle indiquée dans l'exemple 3. Le produit résultant conduit à un coefficient de dilatation de 2,5 à $3 \times 10^{-6}$ cm/cm/°C quelle que soit la direction de mesure prise dans le plan de stratification.

**Revendications**

1. Substrats isotropes métallisables caractérisés en ce qu'ils présentent un coefficient de dilatation thermique entre —65 °C et 125 °C variant de 3 à $12 \times 10^{-6}$ cm/cm/°C et en ce qu'ils sont constitués par :

— de 10 à 60 % en poids de fibrettes dont la longueur moyenne est inférieure ou égale à 25 mm,
— de 10 à 70 % en poids de charges pulvérulentes ou sous forme de particules,
— de 20 à 70 % en poids de liant pour des fibrettes et charges,

les fibrettes comprenant une proportion majoritaire de fibrettes de matières polymériques dont les propriétés mécaniques sont maintenues au-dessus de 200 °C et qui présentent un coefficient de dilatation thermique faible, au sens ci-avant, voire négatif,

les charges pulvérulentes comprenant de 40 à 100 % en poids de particules d'oxyde cuivreux de granulométrie comprise entre 0,1 et 5 microns,

le liant comprenant de 25 à 100 % en poids de polymère à groupements imides.

2. Substrats selon la revendication 1, caractérisés en ce que les fibrettes polymériques sont des fibrettes de polyamide aromatique.

3. Substrats selon la revendication 1 ou 2, caractérisés en ce que le liant résulte du durcissement d'un prépolymère de polyimide obtenu par réaction entre un N,N'-bis-imide d'acide dicarboxylique non saturé, une polyamine primaire et éventuellement un adjuvant tel que notamment un monoimide, un monomère polymérisable comportant un ou plusieurs groupements du type $CH_2{=}C{=}$, un polyester insaturé, un composé organosilicique hydroxylé.

4. Substrats selon l'une quelconque des revendications précédentes, caractérisés en ce qu'ils présentent en outre sur au moins une portion de surface une couche métallique, cohérente et enracinée dans l'épaisseur du substrat par l'intermédiaire de cuivre métallique.

5. Procédé de fabrication des substrats selon l'une quelconque des revendications 1 à 3, le procédé comprenant les étapes suivantes :

a) la préparation d'une dispersion, directement dans l'eau, de l'ensemble constitué par les fibrettes, les charges pulvérulentes ou sous forme de particules et le liant sous forme de poudre, ledit liant étant, soit sous forme d'un polymère, soit sous forme de prépolymère de faible masse moléculaire, pour former une pâte,

b) la formation d'une nappe à partir de cette pâte, par élimination de l'eau, suivie le cas échéant, d'un léger pressage et séchage et,

c) le pressage à chaud de la nappe ainsi formée à une température comprise entre 70 et 280 °C sous une pression comprise entre $10^6$ et $3 \cdot 10^7$ Pa (10 et 300 bars).

6. Procédé de fabrication des substrats selon la revendication 4, le procédé comprenant les étapes suivantes :

a) la préparation d'une dispersion, directement dans l'eau, de l'ensemble constitué par les fibrettes, les charges pulvérulentes ou sous forme de particules et le liant sous forme de poudre, ledit liant étant, soit sous forme d'un polymère, soit sous forme de prépolymère de faible masse moléculaire, pour

former une pâte,

b) la formation d'une nappe à partir de cette pâte, par élimination de l'eau, suivie le cas échéant, d'un léger pressage et séchage,

c) le pressage à chaud de la nappe ainsi formée à une température comprise entre 70 et 280 °C sous une pression comprise entre $10^6$ et $3 \cdot 10^7$ Pa (10 et 300 bars) et,

d) le cas échéant le décapage mécanique et/ou chimique d'au moins une portion de surface,

e) la réduction d'au moins une portion de surface par un borohydrure d'alcalin,

f) le dépôt d'au moins un métal.

## Claims

1. Isotropic substrates capable of being metallized, characterized in that they exhibit a coefficient of thermal expansion between — 65 °C and 125 °C varying from 3 to 12 × $10^{-6}$ cm/cm/°C and in that they consist of :

— from 10 to 60 % by weight of small fibres whose mean length is below or equal to 25 mm,

— from 10 to 70 % by weight of fillers which are pulverulent or in the form of particles, and

— from 20 to 70 % by weight of binder for the small fibres and fillers,

the small fibres comprising a major proportion of small fibres made of polymeric substances whose mechanical properties are maintained above 200 °C and which have a low, or even negative, coefficient of thermal expansion, within the above meaning,

the pulverulent fillers comprising from 40 to 100 % by weight of cuprous oxide particles with a particle size of between 0.1 and 5 microns, and

the binder comprising from 25 to 100 % by weight of polymer containing imide groups.

2. Substrates according to Claim 1, characterized in that the small polymeric fibres are small fibres of aromatic polyamide.

3. Substrates according to Claim 1 or 2, characterized in that the binder is produced by hardening a polyimide prepolymer obtained by reaction between an N,N'-bisimide of an unsaturated dicarboxylic acid, a primary polyamine and, optionally, an adjuvant such as, in particular, a monoimide, a polymerizable monomer containing one or more groups of the $CH_2=C=$ type, an unsaturated polyester, or a hydroxylated organosilicon compound.

4. Substrates according to any one of the preceding claims, characterized in that, over at least a part of the surface, they additionally exhibit a coherent metal layer rooted into the thickness of the substrate by means of metallic copper.

5. Process for the manufacture of the substrates according to any one of Claims 1 to 3, the process comprising the following stages :

a) the preparation of a dispersion, directly in water, of the combination consisting of the small fibres, the fillers which are pulverulent or in the form of particles and the binder in the form of powder, the said binder being either in the form of a polymer or in the form of a prepolymer of low molecular mass, to form a dough,

b) the formation of a sheet from this dough, by removal of water, followed, where appropriate, by a light pressing and drying, and

c) hot pressing of the sheet thus formed at a temperature of between 70 and 180 °C at a pressure of between $10^6$ and $3 \times 10^7$ Pa (10 and 300 bars).

6. Process for the manufacture of the substrates according to Claim 4, the process comprising the following stages :

a) the preparation of a dispersion, directly in water, of the combination consisting of the small fibres, the fillers which are pulverulent or in the form of particles and the binder in the form of powder, the said binder being either in the form of a polymer or in the form of a prepolymer of low molecular mass, to form a dough,

b) the formation of a sheet from this dough, by removal of water, followed, if appropriate, by a light pressing and drying,

c) hot pressing of the sheet thus formed at a temperature of between 70 and 280 °C at a pressure of between $10^6$ and $3 \times 10^7$ Pa (10 and 300 bars), and

d) where appropriate, the mechanical and/or chemical scouring of at least a part of the surface,

e) the reduction of at least a part of the surface with an alkali metal borohydride, and

f) the deposition of at least one metal.

## Patentansprüche

1. Isotrope metallisierbare Substrate, dadurch gekennzeichnet, daß sie einen, zwischen — 65 °C und 125 °C, zwischen 3 bis 12 × $10^{-6}$ cm/cm/°C schwankenden Wärmeausdehnungskoeffizienten aufweisen und sich zusammensetzen aus :

— von 10 bis 60 Gew.-% kleine Fasern einer mittleren Länge von unter oder gleich 25 mm,

— von 10 bis 70 Gew.-% Füllmittel in pulverisierter oder Teilchenform und
— von 20 bis 70 Gew.-% Bindemittel für kleine Fasern und Füllmittel,

wobei die kleinen Fasern einem Hauptbestandteil kleiner, aus polymeren Substanzen hergestellten Fasern ausmachen, deren mechanische Eigenschaften über 200 °C aufrechterhalten bleiben und die einen im obigen Sinne niedrigen, oder sogar negativen Wärmeausdehnungskoeffizienten aufweisen,

die pulverförmigen Füllmittel aus 40 bis 100 Gew.-% Kupferoxidteilchen mit einer Teilchengröße von 0,1 bis 5 Mikron bestehen und

das Bindemittel aus 25 bis 100 Gew.-% Imidogruppen enthaltenden Polymer besteht.

2. Substrate nach Anspruch 1, dadurch gekennzeichnet, daß die kleinen polymeren Fasern kleine Fasern aromatischer Polyamide sind.

3. Substrate nach Anspruch 1 oder 2, dadurch gekennzeichnet, daß das Bindemittel durch Aushärtung eines Polyimidprepolymers gebildet wird, welcher aus der Reaktion zwischen einem N,N'-bisimid einer ungesättigten Dicarbonsäure, einem primären Polyamin und gegebenenfalls einer Adjuvans wie insbesondere einem Monoimid, einem, eine oder mehrere Gruppen vom Typ $CH_2{=}C{=}$ enthaltenden polymerisierbaren Monomer, einem ungesättigten Polyester oder einer hydroxylierten siliziumorganischen Verbindung, hervorgeht.

4. Substrate nach einem der vorhergehenden Ansprüche, dadurch gekennzeichnet, daß sie wenigstens über einen Teil ihrer Oberfläche zusätzlich eine, durch metallisches Kupfer und in der Substratdicke verwurzelte kohärente Metallschicht aufweisen.

5. Verfahren zur Herstellung der Substrate nach einem der Ansprüche 1 bis 3, wobei das Verfahren folgende Schritte umfaßt,

a) daß man zur Bildung eines Breis eine Dispersion, direkt in Wasser, einer Kombination aus Fasern kleiner Größe, den pulver- oder teilchenförmigen Füllmitteln und dem pulverförmigen Bindemittel, wobei besagtes Bindemittel entweder in Form eines Polymers oder eines Prepolymers niedermolekularer Masse vorliegt, bereitet,

b) dessen Formgebung zu einer Lage durch Wasserentzug, wo angemessen, gefolgt von leichtem Pressen und Trocknen erfolgen läßt, sowie

c) die somit erhaltene Lage bei einer Temperatur zwischen 70 und 280 °C unter einem Druck zwischen $10^6$ und $3 \times 10^7$ Pa (10 und 300 Bar) heißpreßt.

6. Verfahren zur Herstellung der Substrate nach Anspruch 4, wobei das Verfahren folgende Schritte umfaßt,

a) daß man zur Bildung eines Breis eine Dispersion, direkt in Wasser, einer Kombination aus Fasern kleiner Größe, den pulver- oder teilchenförmigen Füllmitteln und dem pulverförmigen Bindemittel, wobei besagtes Bindemittel entweder in Form eines Polymers oder eines Prepolymers niedermolekularer Masse vorliegt, bereitet,

b) dessen Formgebung zu einer Lage durch Wasserentzug, wo angemessen, gefolgt von leichtem Pressen und Trocknen erfolgen läßt, sowie

c) die somit erhaltene Lage bei einer Temperatur zwischen 70 und 280 °C unter einem Druck zwischen $10^6$ und $3 \times 10^7$ Pa (10 und 300 Bar) heißpreßt und,

d) wo angemessen, mechanisch und/oder chemisch wenigstens einen Teil der Oberfläche abbeizt,

e) wenigstens einen Teil der Oberfläche mit einem Alkalimetallborhydrid reduziert und

f) wenigstens ein Metall abscheidet.